# EUROPEAN PATENT APPLICATION

(11) **EP 1 930 947 A1**
(43) Date of publication of application: **11.06.2008**
(21) Application number: 07022441.5
(22) Date of filing: 20.11.2007
(51) Int. Cl.: H01L 25/13, F21S 2/00, G02F 1/13357

(54) **Backlight assembly and display device having the same**

(30) Priority: 06.12.2006 KR 20060122737
(71) Applicant: Samsung Electronics Co., Ltd., Suwon-si, Gyeonggi-do 442-742 (KR)
(72) Inventor: Choi, Min-Soo, Cheonan-si Chungcheongnam-do (KR); Kwon, Young-Sup, Dobong-gu Seoul (KR)
(74) Representative: Dr. Weitzel & Partner

(57) **Abstract**

A backlight assembly includes a plurality of blocks and a driving substrate. Each of the blocks includes a plurality of light emitting diodes. Sides of adjacent blocks are fitted to each other. The light emitting diodes are mounted on the driving substrate.

## Description

### BACKGROUND OF THE INVENTION

### 1. Technical Field

The present disclosure relates to a backlight assembly and a display device having the backlight assembly. More particularly, the present disclosure relates to a backlight assembly capable of improving an image display quality and a display device having the backlight assembly.

### 2. Discussion of Related Art

A liquid crystal display (LCD) device, which is one of various kinds of flat panel display devices, displays an image by using electrical and optical characteristics of liquid crystals. The LCD device has various characteristics, such as small thickness, light weight, low power consumption, low driving voltage, and the like. Thus, the LCD device has been widely used as a display in various applications.

The LCD device includes an LCD panel and a backlight assembly. The LCD panel displays an image using the light transmittance of the liquid crystals. The backlight assembly is disposed under the LCD panel to provide the LCD panel with light to be transmitted thereby.

The LCD panel includes an array substrate, an opposite substrate and a liquid crystal layer. The array substrate includes a plurality of thin film transistors formed in a plurality of pixels. The opposite substrate includes a plurality of color filters. The liquid crystal layer is interposed between the array substrate and the opposite substrate. The color filters correspond to the pixels, respectively. The color filters include red color filter, green color filter, and a blue color filter.

The backlight assembly includes a light source generating sufficient light so that the LCD panel can display the image. The light source can have various embodiments, such as a cold cathode fluorescent lamp (CCFL), a flat fluorescent lamp (FFL), a light emitting diode (LED), and the like.

The light emitting diode can have various shapes, such as a chip shape and can have various characteristics, such as high luminance, low power consumption, and the like. Thus, the light emitting diode has been widely used as the light source of the backlight assembly for the LCD assembly. A plurality of light emitting diodes, in general, is disposed on a driving substrate, and includes a red light emitting diode, a green light emitting diode, and a blue light emitting diode.

All of the light emitting diodes, in general, are turned on at the same time to generate the light. When all of the light emitting diodes are turned on, however, the lifetime of the light emitting diodes is decreased and a power consumption of the backlight assembly is increased.

Also, when the light emitting diodes are individually operated to decrease the power consumption of the backlight assembly, an interface between a region in which the light emitting diodes are turned on and an adjacent region in which the light emitting diodes are turned off is displayed on the LCD panel as a straight line, thereby deteriorating an image display quality of the LCD device.

### SUMMARY OF THE INVENTION

Exemplary embodiments of the present invention provide a backlight assembly capable of improving an image display quality.

Exemplary embodiments of the present invention also provide a display device having the above-mentioned backlight assembly.

A backlight assembly in accordance with an exemplary embodiment of the present invention includes a plurality of blocks and a driving substrate.

Each of the blocks includes a plurality of the light emitting diodes. The blocks may be independently operated. Sides of adjacent blocks are fitted to each other. The sides of the adjacent blocks may have a saw-tooth shape. The light emitting diodes are mounted on the driving substrate.

The blocks may include a plurality of first blocks and a plurality of second blocks being adjacent the first blocks and fitted to the first blocks. Positions of the second blocks adjacent one of the first blocks may have a rotation symmetry with respect to a center of the first block by a constant rotation angle. The rotation angle may be about 90 degrees or about 60 degrees. Sides of each of the first and second blocks may have a substantially triangular saw-tooth shape or a substantially quadrangular saw-tooth shape.

A display device in accordance with an exemplary embodiment of the present invention includes a backlight assembly and a display panel.

The backlight assembly includes a plurality of blocks and a driving substrate on which the light emitting diodes are mounted. Each of the blocks includes a plurality of light emitting diodes, and the blocks may be independently operated. Sides of adjacent blocks are fitted to each other. The sides of the adjacent blocks may have a saw-tooth shape. The display panel is arranged on the backlight assembly in order to display an image.

The display device may further include a controller unit electrically connected to the backlight assembly and the display panel to control the backlight assembly and the display panel.

According to an exemplary embodiment of the present invention, the sides of the adjacent blocks have the saw-tooth shape and are fitted to each other, so that the luminance is gradually changed on the interface between the adjacent blocks. Thus, the image display quality of the display device is improved.

### BRIEF DESCRIPTION OF THE DRAWINGS

Exemplary embodiments of the present invention will be understood in more detail from the following descriptions taken in conjunction with the accompanying drawings, in which:
FIG. 1 is an exploded perspective view illustrating a display device in accordance with an exemplary embodiment of the present invention;
FIG. 2 is a plan view illustrating a plurality of light emitting diodes grouped into a plurality of blocks shown in FIG. 1;
FIG. 3 is an enlarged plan view illustrating a first block and a second block in FIG. 2 adjacent each other;
FIG. 4 is a plan view illustrating the block shown in FIG. 2 and a block in accordance with another exemplary embodiment of the present invention;
FIG. 5 is a plan view illustrating a plurality of light emitting diodes grouped into a plurality of blocks in accordance with an exemplary embodiment of the present invention;
FIG. 6 is an enlarged plan view illustrating the block shown in FIG. 5;
FIG. 7 is a plan view illustrating a plurality of light emitting diodes grouped into a plurality of blocks in accordance with an exemplary embodiment of the present invention; and
FIG. 8 is an enlarged plan view illustrating the block shown in FIG. 7.

### DESCRIPTION OF EXEMPLARY EMBODIMENTS

Exemplary embodiments of the present invention are described more fully hereinafter with reference to the accompanying drawings, in which the exemplary embodiments of the invention are shown. This invention may, however, be embodied in many different forms and should not be construed as limited to the exemplary embodiments set forth herein. Rather, these exemplary embodiments are provided so that this disclosure will be thorough and complete, and will fully convey the scope of the present invention to those of ordinary skill in the art.

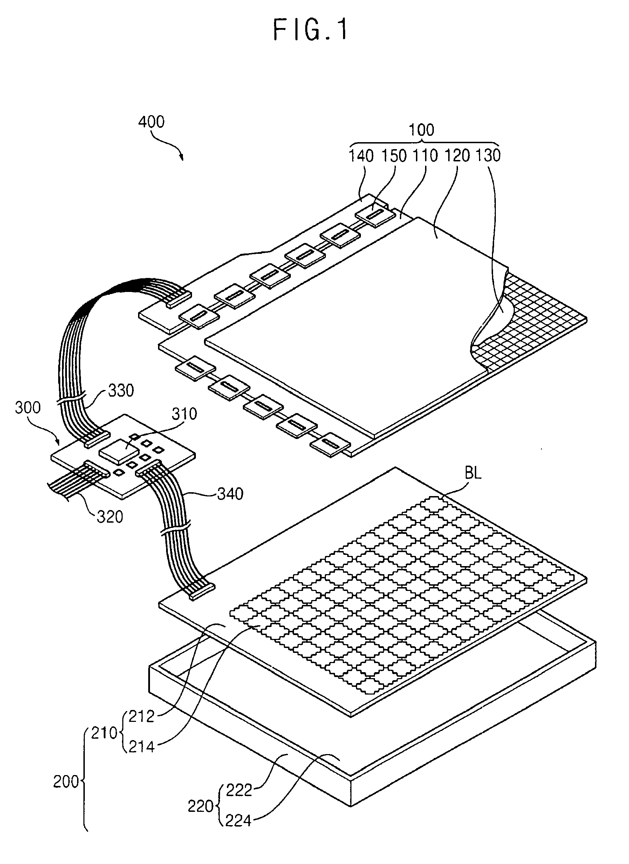

FIG. 1 is an exploded perspective view illustrating a display device in accordance with an exemplary embodiment of the present invention.

Referring to FIG. 1, the display device 400 includes a display panel 100, a backlight assembly 200 and a controller unit 300. The display device 400 displays an image in accordance with image signals fed to the controller unit 300.

The display panel 100 includes an array substrate 110, an opposite substrate 120, a liquid crystal layer 130, a printed circuit board 140, and a flexible circuit film 150.

Although not shown in FIG. 1, the array substrate 110 includes a plurality of pixel electrodes, a plurality of thin film transistors and a plurality of signal lines. The pixel electrodes are arranged in a matrix shape, and include a transparent conductive material. The thin film transistors apply driving voltages to the pixel electrodes, respectively. The thin film transistors are turned on based on signals applied to the thin film transistors through the signal lines.

The signal lines include a plurality of gate lines and a plurality of data lines. The gate lines are extended in a direction different from an extended direction of the data lines. Each of the thin film transistors and each of the pixel electrodes are formed in each of the pixels.

The opposite substrate 120 faces the array substrate 110. Although not shown in FIG. 1, the opposite substrate 120 includes a common electrode and a plurality of color filters. The common electrode is formed on substantially the entire surface of the opposite substrate 120, and includes a transparent conductive material. The plurality of color filters correspond to the plurality of pixels, respectively.

The liquid crystal layer 130 is interposed between the array substrate 110 and the opposite substrate 120. Liquid crystals of the liquid crystal layer 130 vary their arrangement in response to an electric field applied thereto, and the light transmittance of the liquid crystal layer 130 is changed accordingly.

The printed circuit board 140 converts an external control signal that is provided from an exterior to the printed circuit board 140 into an image control signal. When the flexible circuit film 150 is bent backwardly, the printed circuit board 140 is disposed under the array substrate 110. Although not shown, the printed circuit board 140 may include a data printed circuit board and a gate printed circuit board. On the other hand, an additional signal line may be formed on the array substrate and the flexible circuit film 150 so that the gate printed circuit may be omitted.

The printed circuit board 140 is electrically connected to the array substrate 110 through the flexible circuit film 150, so that the image control signal generated from the printed circuit board 140 is applied to the array substrate 110 through the flexible circuit film 150. The flexible circuit film 150 may include a driving chip (not shown) that changes the image control signal into a driving signal for driving the thin film transistors (not shown). Although not shown, the flexible circuit film 150 may include a tape carrier package (TCP) or a chip on film (COF). Alternatively, the driving chip may not be formed on the flexible circuit film 150 but may be formed on the array substrate 110.

The backlight assembly 200 is disposed under the display panel 100 to provide the display panel 100 with light. The backlight assembly 200 includes a backlight assembly 210 that generates the light and a receiving container 220 that receives the backlight assembly 210.

The backlight assembly 210 generates the light for the display panel 100 to display an image. The backlight assembly 210 includes a driving substrate 212 and a plurality of light emitting diodes 214.

The driving substrate 210 may further include a control line (not shown) and a power supply line (not shown). A control signal for controlling the light emitting diodes 214 is applied to the light emitting diodes 214 through the control line, and electric power is applied to the light emitting diodes 214 through the power supply line.

The light emitting diodes 214 are disposed on the driving substrate 210 to generate the required light. The light emitting diodes 214 are electrically connected to the control line to receive the control signal for controlling them, and they are electrically connected to the power supply line to receive the electric power.

The light emitting diodes 214 include a plurality of red light emitting diodes, a plurality of green light emitting diodes and a plurality of blue light emitting diodes. The red light emitting diodes generate red light. The green light emitting diodes generate green light. The blue light emitting diodes generate blue light. In addition, the light emitting diodes 214 may further include a plurality of white light emitting diodes.

The light emitting diodes 214 may be spaced apart from each other by a constant distance. In an exemplary embodiment, the light emitting diodes 214 may be arranged in a matrix shape. In FIG. 1, the light emitting diodes 214 are driven by a local dimming method. In the local dimming method, the light emitting diodes 214 are grouped into a plurality of blocks (BL), and the blocks are independently driven.

The receiving container 220 may include a bottom plate 222 and a plurality of sidewalls 224 protruded from sides of the bottom plate 222 to form a receiving space. The receiving container 220 receives the backlight assembly 210. The receiving container 220 may also receive the display panel 100 on top of the backlight assembly.

The backlight assembly 200 may further include optical sheets (not shown) that are interposed between the display panel 100 and the backlight assembly 210. Although not shown in FIG. 1, the optical sheets may include a diffusion plate that increases luminance uniformity and at least one prism sheet that increases luminance when viewed at an angle.

The controller unit 300 is electrically connected to the display panel 100 and the backlight assembly 210 to control the display panel 100 and the backlight assembly 210. The controller unit 300 includes a controlling circuit 310, a first connecting cable 320, a second connecting cable 330 and a third connecting cable 340.

In an exemplary embodiment, the controlling circuit 310 is electrically connected to a main system (not shown), the printed circuit board 140 of the display panel 100 and the backlight assembly 210 through the first connecting cable 320, the second connecting cable 330 and the third connecting cable 340, respectively.

The controlling circuit 310 generates the image control signal and a light source control signal based on a circuit control signal that is fed from the main system (not shown). The image control signal is applied to the display panel 100 to drive the thin film transistors in the pixels. The light source control signal is applied to the backlight assembly 210 to independently drive the light emitting diodes 214 in the blocks BL.

In FIG. 1, the backlight assembly 210 is integrally formed with the driving substrate 212 to drive the light emitting diodes 214. Alternatively, the backlight assembly 210 may include a plurality of driving substrates corresponding to the blocks, respectively. For example, each of the blocks BL may correspond to each of the driving substrates.

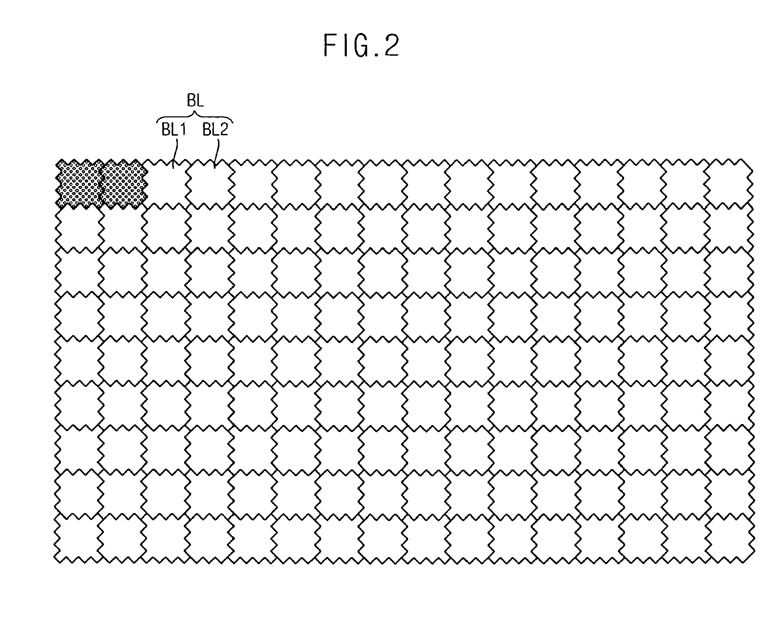

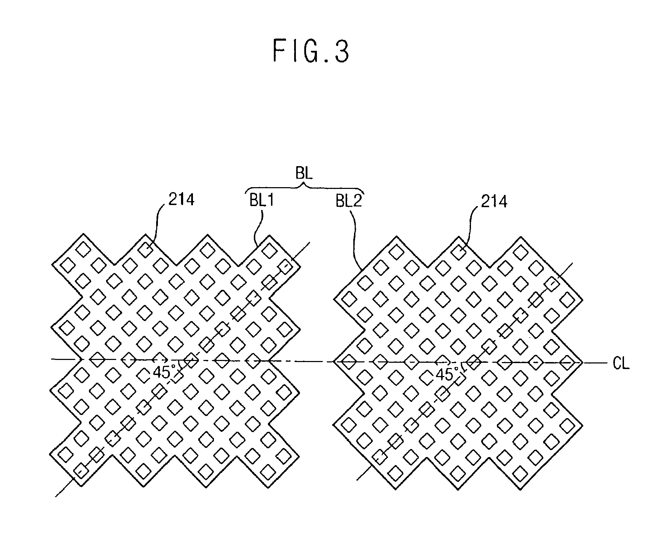

FIG. 2 is a plan view illustrating a plurality of light emitting diodes grouped into a plurality of blocks as shown in FIG. 1. FIG. 3 is an enlarged plan view illustrating a first block and a second block in FIG. 2 that are adjacent each other.

Referring to FIGS. 2 and 3, the light emitting diodes 214 are grouped into the blocks BL. The blocks BL are independently operated to generate the required light.

In an exemplary embodiment, each of the blocks BL has a saw-tooth edge shape so that the block BL is fitted to an adjacent block BL.

Hereinafter, each of the blocks BL will be described, in detail.

In an exemplary embodiment, the blocks BL includes a plurality of first blocks BL1 and a plurality of second blocks BL2. The second blocks BL2 are adjacent the first blocks BL1, and are fitted to the first blocks BL1. In an exemplary embodiment, each of the second blocks BL2 is adjacent each of the first blocks BL1 and is fitted to the adjacent first block BL1.

In FIG. 2, positions of the second blocks BL2 adjacent one of the first blocks BL1 have a rotation symmetry with respect to a center of the first block BL1 by a constant rotation angle, and are fitted to the first block BL1. Also, positions of the first blocks BL1 adjacent one of the second blocks BL2 have a rotation symmetry with respect to a center of the second block BL2 by a constant rotation angle.

The rotation angle may be about 360/N degrees, wherein N is a natural number of no less than three. For example, the rotation angle may be about 120 degrees, about 90 degrees, about 72 degrees, about 60 degrees, about 51.4 degrees, or about 45 degrees. In an exemplary embodiment, the rotation angle may be about 90 degrees or about 60 degrees. When the rotation angle is about 90 degrees, the blocks BL form a substantially square shape or a substantially rectangular shape. Alternatively, when the rotation angle is about 60 degrees, the blocks BL form a substantially hexagonal shape. In FIG. 2, the rotation angle is about 90 degrees.

The first blocks BL1 may have substantially the same shape as the second blocks BL2. Alternatively, the first blocks BL1 may have a different shape from the second blocks BL2. In FIGS. 2 and 3, the first block BL1 has a different shape from the second block BL2.

Sides of each of the first and second blocks BL1 and BL2 have a triangular saw-tooth shape or a quadrangular saw-tooth shape. Alternatively, the sides of each of the first and second blocks BL1 and BL2 may have a trapezoidal saw-tooth shape. In exemplary embodiments, the sides of each of the first and second blocks BL1 and BL2 have an isosceles triangular saw-tooth shape, a rectangular saw-tooth shape or an isosceles trapezoidal saw-tooth shape. In FIG. 2, the sides of each of the first and second blocks BL 1 and BL2 have the isosceles triangular saw-tooth shape.

In FIG. 3, the first block BL1 may have a different shape from the second block BL2.

Referring again to FIG. 3, positions of the second blocks BL2 adjacent the first block BL1 have a rotation symmetry with respect to the center of the first block BL1 by the rotation angle of about 90 degrees, and are fitted to the first block BL1. In FIG. 3, although not shown, there would be three more second blocks BL2 adjacent the other sides. The blocks BL including the first and second blocks BL1 and BL2 form a rectangular shape or a square shape. In addition, the sides of each of the first and second blocks BL1 and BL2 have the triangular saw-tooth shape.

Corners of each of the first blocks BL 1 have different shapes from those of each of the second blocks BL2. The corners of each of the first blocks BL1 have a protruded shape, and the corners of each of the second blocks BL2 have a flat shape. In addition, the number of triangles formed on the sides of each of the first blocks BL1 is greater than the number of triangles formed on the sides of each of the second blocks BL2, that is, there are three corner triangles on first blocks BL1 and two corner triangles on second blocks BL2.

The light emitting diodes 214 are spaced apart from each other in each of the blocks BL, and a density of the light emitting diodes 214 in each of the blocks BL is constant.

The light emitting diodes 214 may be aligned along a central line CL crossing the centers of the adjacent first and second blocks BL1 and BL2. Alternatively, the light emitting diodes 214 may be aligned in a direction substantially perpendicular to the central line CL crossing the centers of the adjacent first and second blocks BL1 and BL2. The light emitting diodes 214 may also be aligned in a direction inclined with respect to the central line CL crossing the centers of the adjacent first and second blocks BL1 and BL2. In an exemplary embodiment, the aligning direction of the light emitting diodes 214 may form an angle of about 45 degrees with respect to the central line CL crossing the centers of the adjacent first and second blocks BL1 and BL2.

According to the display device shown in FIGS. 1 to 3, an interface between adjacent blocks BL has a saw-tooth shape, so that the luminance is gradually changed on the interface even though one of the blocks BL is turned on and the adjacent block BL is turned off.

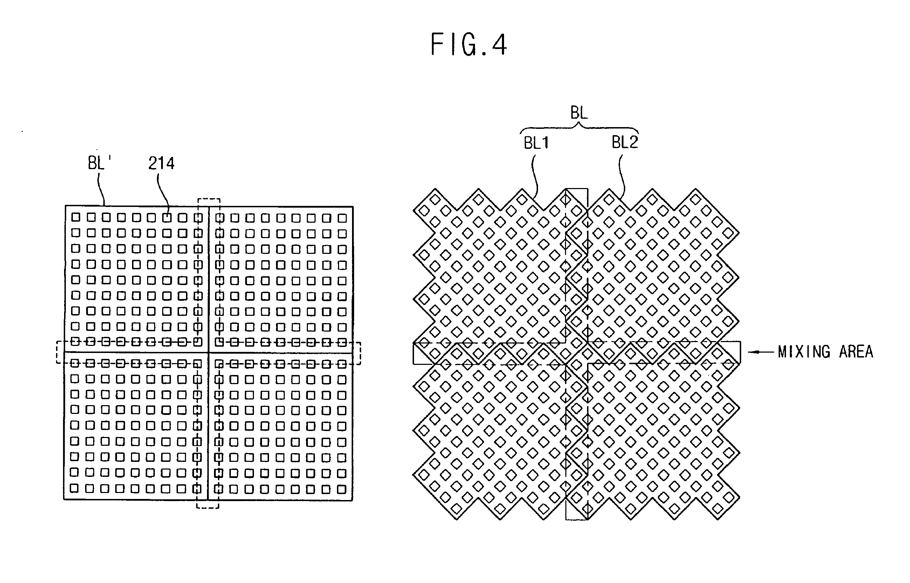

FIG. 4 is a plan view illustrating a part of the block shown in FIG. 2 and a block in accordance with a previously proposed construction.

Referring to FIG. 4, a luminance difference on an interface between adjacent blocks BL will be explained as follows.

Flat sided blocks BL' have a substantially rectangular shape or a substantially square shape, and an interface between adjacent flat sided blocks BL' has a linear shape as shown by the dashed line cruciform in FIG. 4. When one of the adjacent flat sided blocks BL' is turned on and a remainder of the adjacent flat sided blocks BL' are turned off, the interface between the adjacent flat sided blocks BL' is displayed as a line.

When each of blocks BL has a saw-tooth shape and adjacent blocks BL are fitted to each other, however, a mixing area is formed between the adjacent blocks BL. The mixing area is formed in a region in which sides of the adjacent blocks BL are fitted to each other.

When light emitting diodes 214 of the first blocks BL1 are turned on and light emitting diodes 214 of the second blocks BL2 are turned off, the luminance of the mixing area is between the luminance of a center of the first block BL 1 and the luminance of a center of the second block BL2. Therefore, the luminance is gradually changed in the mixing area, so that the interface between the first and second blocks BL 1 and BL2 is not displayed.

When red, green and blue light emitting diodes are unequally arranged in the mixing area, color reproducibility of a display device may be deteriorated. In FIG. 4, however, white light emitting diodes are disposed in the mixing area, so that color reproducibility is increased, even though the white light emitting diodes are not equally arranged in the mixing area.

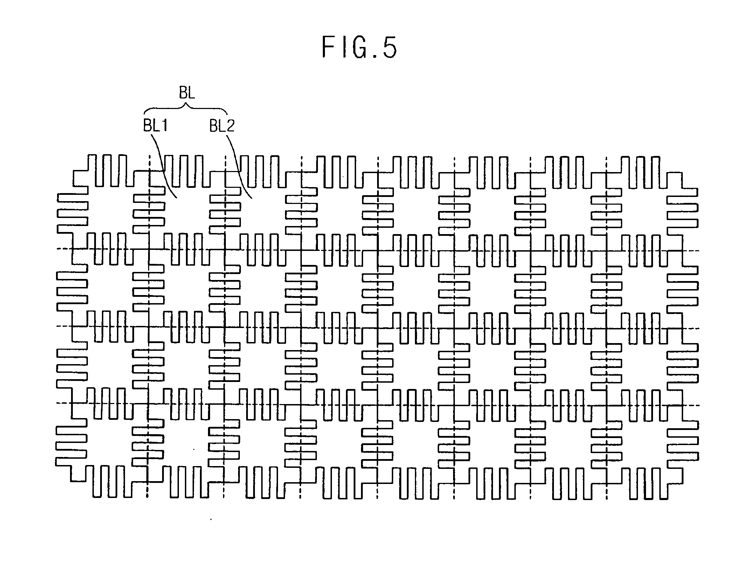

FIG. 5 is a plan view illustrating a plurality of light emitting diodes grouped into a plurality of blocks in accordance with an exemplary embodiment of the present invention. The blocks of FIG. 5 have a different shape from those shown in FIG. 2.

Referring to FIG. 5, all of the blocks BL have substantially the same shape. In this exemplary embodiment, each of the first blocks BL1 has substantially the same shape as each of the second blocks BL2 that are adjacent the first blocks BL1.

Positions of the second blocks BL2 adjacent one of the first blocks BL1 have a rotation symmetry with respect to a center of the first block BL1 by about 90 degrees and are fitted to the first block BL1. Each of the blocks BL has a substantially rectangular shape or a substantially square shape. Also, sides of each of the blocks BL have a rectangular saw-tooth shape.

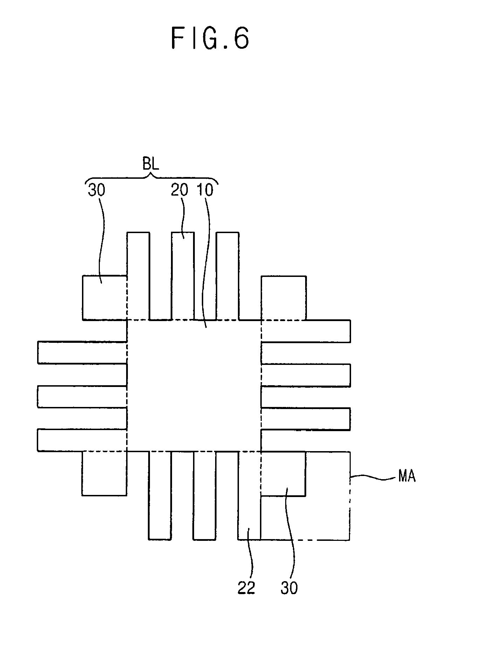

FIG. 6 is an enlarged plan view illustrating one of the blocks shown in FIG. 5.

Referring to FIG. 6, the shape of each of the blocks BL will be described in detail. The unit block BL includes a body portion 10, a main branch 20 and a sub branch 30. Alternatively, the unit block BL may have a plurality of main branches 20 and a plurality of sub branches 30.

The body portion 10 may have a substantially rectangular shape or a substantially square shape in a plan view. A plurality of main branches 20 may be extended from the sides of the body portion 10 in a horizontal direction and a longitudinal direction. Each of the main branches 20 has a substantially rectangular shape.

Each of the sub branches 30 is protruded from each of the main branches 20 adjacent a corner region MA of the block BL toward the corner region MA. Each of the sub branches 30 may have a substantially rectangular shape or a substantially square shape.

The corner region MA corresponds to each of the four corners of the block BL. The corner region MA may have a substantially rectangular shape or a substantially square shape. The number of the sub branches 30 may be four.

In an exemplary embodiment, an area of one of the sub branches 30 is about one-fourth of an area of the corner region MA, and four sub branches 30 of adjacent four blocks BL may be fitted to each other to fill the corner region MA.

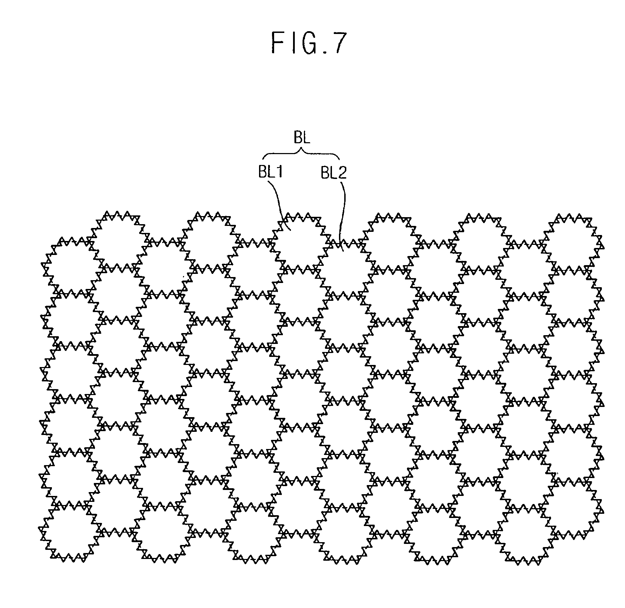

FIG. 7 is a plan view illustrating a plurality of light emitting diodes grouped into a plurality of blocks in accordance with an exemplary embodiment of the present invention.

Referring to FIG. 7, the blocks BL, including a plurality of first blocks BL1 and a plurality of second blocks BL2, have substantially the same shape, that is, each of the first blocks BL1 has substantially the same shape as each of the second blocks BL2.

Positions of the second blocks BL2 adjacent one of the first blocks BL1 have a rotation symmetry by about 60 degrees with respect to a center of the first block BL1, and are fitted to the first block BL1. In an exemplary embodiment, each of the blocks BL has a substantially hexagonal shape, and each side of the hexagonal shape has an isosceles triangular saw-tooth shape.

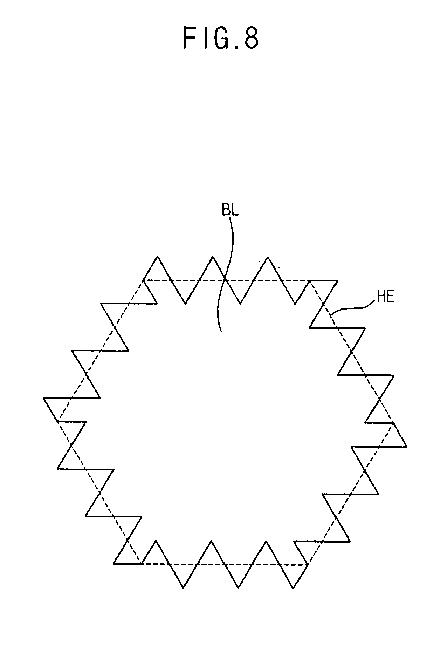

FIG. 8 is an enlarged plan view illustrating one of the blocks shown in FIG. 7.

Referring to FIG. 8, the shape of each of the blocks BL will be described in detail. Each of the sides of the block BL has convex and concave shapes with respect to a hexagonal line HE of the block BL. Each of the convex and concave shapes has a substantially isosceles triangular shape, and has substantially the same area. In addition, the six sides of the block BL have substantially the same shape and size.

In FIGS. 1 to 8, four example blocks BL are described, however, the blocks BL may have various shapes.

According to exemplary embodiments of the present invention, the sides of the adjacent blocks have the saw-tooth shape and are fitted to each other, so that the luminance is gradually changed on the interface between the adjacent blocks. Thus, image display quality of the display device may be improved.

When the sides of the adjacent flat sided blocks have a straight line, the luminance difference between the adjacent flat sided blocks may be seen on the interface between the sides of the straight line. When the sides of the adjacent blocks have the saw-tooth shape and are fitted to each other, however, the mixing area may be formed between the adjacent blocks so that the luminance in the mixing area may be between the luminance of a center of a bright block and the luminance of a center of a dark block. Thus, although the adjacent blocks are independently operated, the luminance is gradually changed between the adjacent blocks.

The present invention has been described with reference to exemplary embodiments. It is evident, however, that many alternative modifications and variations will be apparent to those having ordinary skill in the art in light of the foregoing description. Accordingly, the present invention embraces all such alternative modifications and variations as fall within the spirit and scope of the appended claims.

## Claims

1. A backlight assembly comprising:
a plurality of blocks, each of the blocks including a plurality of light emitting diodes, sides of adjacent blocks being fitted to each other; and
a driving substrate on which the plurality of light emitting diodes are mounted.

2. The backlight assembly of claim 1, wherein the blocks are independently operated.

3. The backlight assembly of claim 2, wherein positions of second blocks adjacent one of first blocks have a rotation symmetry with respect to a center of the first block by a constant rotation angle.

4. The backlight assembly of claim 3, wherein the rotation angle is one of about 90 degrees and about 60 degrees.

5. The backlight assembly of claim 3, wherein each of the plurality of first blocks and the plurality of second blocks have substantially the same shape.

6. The backlight assembly of claim 5, wherein sides of each of the plurality of first blocks and the plurality of second blocks have a substantially triangular saw-tooth shape.

7. The backlight assembly of claim 5, wherein sides of each of the plurality of first blocks and the plurality of second blocks have a substantially quadrangular saw-tooth shape.

8. The backlight assembly of claim 3, wherein the plurality of first blocks have a different shape from the second blocks.

9. The backlight assembly of claim 8, wherein positions of the second blocks adjacent one of the first blocks have a rotation symmetry by an angle of about 90 degrees with respect to a center of the first block, and
the sides of each of the plurality of first blocks and the plurality of second blocks have a substantially triangular saw-tooth shape.

10. The backlight assembly of claim 9, wherein the plurality of light emitting diodes are aligned in a direction forming an angle of about 45 degrees with respect to a central line crossing centers of adjacent first and second blocks.

11. The backlight assembly of claim 1, wherein the driving substrate comprises a plurality of unit substrates corresponding to the plurality of blocks, respectively.

12. The backlight assembly of claim 1, wherein the plurality of light emitting diodes comprise a plurality of red light emitting diodes, a plurality of green light emitting diodes and a plurality of blue light emitting diodes.

13. The backlight assembly of claim 1, wherein the plurality of light emitting diodes comprise a plurality of white light emitting diodes.

14. A display device comprising:
a backlight assembly including:
a plurality of blocks, each of the blocks including a plurality of light emitting diodes, sides of adjacent blocks being fitted to each other; and
a driving substrate on which the plurality of light emitting diodes are mounted; and
a display panel arranged on the backlight assembly to display an image.

15. The display device of claim 14, further comprising a controller unit electrically connected to the backlight assembly and the display panel to control the backlight assembly and the display panel.

16. The display device of claim 14, wherein the blocks are independently operated.

17. The display device of claim 14, wherein the display panel comprises:
an array substrate including a thin film transistor;
an opposite substrate facing the array substrate; and
a liquid crystal layer interposed between the array substrate and the opposite substrate.

18. The display device of claim 14, wherein the plurality of blocks comprises:
a plurality of first blocks; and
a plurality of second blocks adjacent the first blocks and fitted to the first blocks.

19. The display device of claim 18, wherein positions of the second blocks adjacent one of the first blocks have a rotation symmetry by a constant rotation angle with respect to a center of the first block.

20. The display device of claim 19, wherein the rotation angle is one of about 90 degrees and about 60 degrees.
